# EUROPEAN PATENT APPLICATION

(11) **EP 1 118 696 A1**
(43) Date of publication of application: **25.07.2001**
(21) Application number: 99940656.4
(22) Date of filing: 03.09.1999
(51) Int. Cl.: C25D 3/38

(54) **METHOD FOR PLATING SUBSTRATE AND APPARATUS**

(30) Priority: 03.09.1998 JP 24945398; 03.08.1999 JP 22036399
(71) Applicant: EBARA CORPORATION, Ohta-ku, Tokyo 144-8510 (JP)
(72) Inventor: NAGAI, Mizuki, Ohta-ku, Tokyo 144-8510 (JP); HONGO, Akihisa, Ohta-ku, Tokyo 144-8510 (JP); OHNO, Kanji, Sagamihara-shi, Kanagawa 228-0827 (JP); ISHII, Kazuo, Chigasaki-shi, Kanagawa 253-0084 (JP); KIMIZUKA, Ryoichi, Setagaya-ku, Tokyo 156-0043 (JP); MARUYAMA, Megumi, Yokohama-shi, Kanagawa 226-0027 (JP)
(74) Representative: Wagner, Karl H., Dipl.-Ing.
(86) International application number: JP9904797
(87) International publication number: WO0014306

(57) **Abstract**

The present invention is to provide a copper damascene plating method for efficiently filling fine wiring trenches and via holes formed in a surface of a substrate without using special machines or electrical facilities, while preventing from generation of air bubbles.

The plating method for filling trenches or via holes formed in a surface of a substrate with copper plating, comprises: performing electrolytic plating using a plating solution comprising copper sulfate (CuSO₄·5H₂O) having a concentration of 4-250 g/l, sulfuric acid (H₂SO₄) having a concentration of 10-200 g/l, and chlorine ions having a concentration of 0-100 mg/l. In addition, a sulfur compound additive can be mixed in to make the solution more suitable for copper damascene plating, wherein the concentration of the additive is selected based on the ratio of sulfuric acid/hydrated copper sulfate.

## Description

### Technical Field

The present invention relates to a method and apparatus for plating the surface of a substrate, and particularly to a method and apparatus for filling fine trenches and via holes formed in a semiconductor wafer as wiring paths with copper plating. The present invention also relates to a composition of the plating solution used in the above method and apparatus.

### Background Art

In order to grow a uniform plating layer in through-holes formed in a printed circuit board using copper plating, the concentration of copper in the plating solution is lowered in the electrolytic plating process, thereby increasing the throwing power (as in a high throw bath) by increasing the polarization of the cathode. This method increases the overvoltage of the cathode and improves the uniformity of electrodeposition. However, a certain degree of solution flow through the holes can be expected when the dimensions of the holes in the printed circuit board are approximately 50-100 *µ* m.

The trenches or vias for wiring that are formed in the surface of a semiconductor wafer, however, have a width or diameter of 0.2 *µ*m or less and do not pass through the wafer. Hence, it is impossible to generate a flow of solution through trenches or vias this minute. Further, the electrophoresis speed generated by the electric field is numerically small, enabling copper ions to fill the holes almost entirely by the diffusion of ion concentration. The amount of diffusion of copper ions in the holes decreases inversely proportional to square of the hole diameter (the area of the entrance to the hole) .

In contrast, the amount of deposition of copper ions in the hole grows approximately in inverse proportion to the diameter of the hole. Accordingly, copper ions can be expected to be diffusion-controlled in trenches and vias, as semiconductor devices become more integrated and the width of trenches and diameters of vias become smaller in the future. When the hole diameters drop below 0.15 *µ*m, in particular, the method of agitating plating solution having a large aspect ratio will tend to be diffusion-controlled.

### Disclosure of Invention

In view of the foregoing, it is an object of the present invention to provide a method and apparatus of plating a substrate, such as a semiconductor wafer. The method is a copper damascene wiring method capable of effectively filling fine trenches and via holes with a copper plating, without requiring special mechanical or electrical equipment.

It is another object of the present invention to provide a method and apparatus of plating a substrate capable of sufficiently filling fine trenches and vias that are formed in the surface of a wafer using a copper plating, without copper ions becoming diffusion-controlled in the trenches and vias, even when the trench widths and via diameters become smaller as the integration in the semiconductor devices increases.

The inventors of the present invention thoroughly investigated a copper plating bath appropriate for the copper damascene method. From this investigation, they discovered that an acidic copper plating solution having the principal components of copper sulfate, sulfuric acid, and chlorine ions within a fixed concentration could deposit a copper layer in fine trenches and vias having a high aspect ratio with good filling ability and little generation of gas bubbles.

They also discovered that the copper plating solution could be made even more suitable for the copper damascene method by adding a sulfur compound and a high polymer at concentrations chosen based on a ratio of sulfuric acid/hydrated copper sulfate.

Hence, the present invention employs a copper plating solution for copper damascene wiring with copper sulfate having a concentration of 4-250 g/l (and preferably 100-250 g/l); sulfuric acid having a concentration of 10-200 g/l (and preferably 10-100 g/l); and chlorine ions having a concentration of 0-100 mg/l.

The copper plating of the present invention also includes a sulfur compound of 0.05-10 mg/l when the ratio of sulfuric acid/hydrated copper sulfate is less than 1 and 0.1-50 mg/l when the ratio of sulfuric acid/hydrated copper sulfate is greater than 1.

The plating solution for copper damascene wiring also includes at least 0.14-70 *µ* mol/l of a sulfur compound, 10 mg/1-5 g/l of a high polymer, and 0.01-100 mg/l of a nitrogen compound.

### Brief Description of Drawings

Fig. 1 is a graph showing the relationship between the amount of a sulfur compound additive that is particularly desirable for depositing copper plating in fine wiring trenches and holes and the B/A ratio;
Fig. 2 is a graph comparing diffusion and deposition amounts in via holes in the wafer;
Fig. 3 is an explanatory diagram showing the shape of a via hole formed in the surface of the wafer;
Fig. 4 shows the construction of a plating bath used in the plating apparatus of the present invention; and
Fig. 5 is an enlarged view of the region B in Fig. 4.

### Best Mode for Carrying Out the Invention

A copper plating solution for copper damascene wiring according to a first embodiment of the present invention includes the basic components of copper sulfate, sulfuric acid, and ordinary chlorine ions at concentrations of 4-250 g/l of copper sulfate, 10-200 g/l of sulfuric acid, and 0-100 mg/l of chlorine ions. It is further desirable that the ratio of sulfuric acid/hydrated copper sulfate (also referred to as the B/A ratio) in the solution be about 0.1-25, and preferably about 0.2-5.

In addition, a sulfur compound can be added to the copper plating solution for copper damascene wiring (hereinafter referred to as "copper damascene plating solution") . An example of the sulfur compound is an alkylene polysulfide compound expressed by the formula(I);

Y-(S)ₙ-L-X (I),

where L is an alkylene group with a carbon number from 1 to 6 that can be replaced by a lower alkyl group, a lower alkoxyl group, a hydroxyl group, or a halogen atom; X is a hydrogen atom, a -SO₃M group, or a -PO₃M group (M indicating a hydrogen atom, an alkali metal atom, or an amino group) ; and Y is an alkylaminocarbothio group or the group;

-L'-X'

(where L' is an alkylene group with a carbon number from 1 to 6 that can be replaced by a lower alkyl group, a lower alkoxyl group, a hydroxyl group, or a halogen atom; and X' is a -SO₃M group or a -PO₃M group); and n is an integer between 1 and 5.

This sulfur compound can achieve a function that the deposited material becomes dense. Some examples of these compounds include N, N-dimethyl-dithiocarbamoyl propylsulfonic acid, O-ethyl-S-(3-propylsulfonic acid)-dithiocarbonate, bis-(sulfopropyl) disulfide, and their salts.

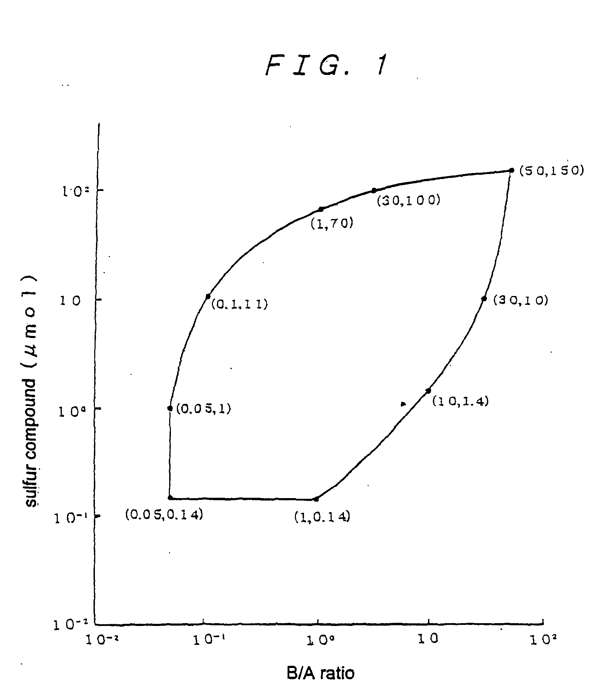

In the present invention, the amount of sulfur compound added to the copper damascene plating solution must be determined according to the B/A ratio in the copper damascene plating solution. More specifically, the amount of sulfur compound must be 0.14-70 *µ* mol/l when the B/A ratio is 1 or less than 1 and 0.14-150 *µ* mol/l when the B/A ratio is 1 or greater than 1. Fig. 1 shows the most desirable range of values for the sulfur compound and the B/A ratio. In the graph, the y-axis represents the amount of sulfur compound additive (*µ*mol), while the x-axis represents the B/A ratio. The following nine points delineate the most desirable range of values: (0.05, 0.14), (0.05, 1), (0.1, 11), (1, 70), (30, 100), (50, 150) , (30, 10), (10, 1.4) , and (1, 0.14).

It is also possible to mix a high molecular organic additive with the copper damascene plating solution of the present invention. An example of the high molecular organic additive is expressed by the formula(II); 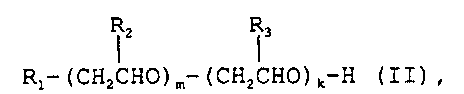 wherein R₁ indicates a higher alcohol rest group having carbon number of 8-25, an alkylphenol rest group with an alkyl group of carbon number 1-25, an alkylnaphthol rest group with an alkyl group of carbon number 1-25, a fatty acid amide rest group of carbon number 3-22, an alkylamine rest group of carbon number 2-4, or a hydroxyl group; R₂ and R₃ indicate a hydrogen atom or a methyl group; and m and k indicate an integer from 1 to 100.

The high molecular organic additive serves to suppress the deposition of copper by polarizing the deposition potential of copper. Some examples of this high molecular organic additive are PPG and PEG, their random or block polymers, or a derivative thereof, such as a polyether type. The amount of high-molecular organic additive is approximately 10 mg/1-5 g/l.

A nitrogen compound can be added to the above plating solution to suppress the copper deposition and to level the surface of the deposited material. The nitrogen compound contains a phenazine compound, phthalocyanine compound, polyethylene imine, polybenzyl ethylene imine, or other polyalkylene imine and derivative thereof; an N-dye substitute compound or other thiorurea derivative; a phenosafranine, safranine azo naphthol, diethyl safranine azo phenol, dimethyl safranine dimethyl aniline, or other safranine compound; a polyepichlorohydrine and a derivative thereof; a thioflavine or other phenylthiazonium compound; an acrylamide, propylamide, polyacrylic acid amide, or other amide type. This nitrogen compound additive is preferably approximately 0.01-100 mg/l.

Using the copper damascene plating solution of the present invention described above, a copper plating process is conducted on wiring trenches and vias formed in the surface of a semiconductor wafer, the trenches or vias having a width or diameter of less than 1.0 *µ* m, and normally 0.1-0.2 *µ*m, and an aspect ratio of 0.1-50. The plating process can be performed in line with normal acidic copper plating without requiring a special mechanical or electrical step to fill the trenches and vias with copper.

More specifically, the plating process should be performed with a bath temperature of 15-35°C and a current density of 0.02-5 A/dm², and preferably 0.1-3 A/dm², generated by a normal DC power source. A pump or other mechanism should be used to shake the product or stir the solution. Trenches and vias having a width or diameter of 0.2-1 *µ* m and an aspect ratio of 1-5 can be entirely filled in a plating time of about 0.5-5 minutes.

The copper damascene plating process of the present invention described above can uniformly deposit copper metal all the way to the inside of trenches and vias that are extremely minute and have a high aspect ratio. Once the plating is completed, chemical mechanical polishing (CMP) can be performed to form fine wiring trenches and wiring vias in the surface of the semiconductor wafer.

Next, preferred embodiments will be given to describe the present invention in more detail. However, the present invention is not limited to these embodiments.

### [First Embodiment]

The copper sulfate plating solution was replenished according to the following composition. Via holes with a diameter of 0.2 *µ* m and a depth of 0.4 *µ* m formed in a silicon wafer (sample) were coated with a conductive copper layer through a sputtering process. The silicon wafer was then plated using the above copper sulfate plating solution under the conditions listed below.

The process resulted in a copper layer having a semi-gloss appearance. By cutting a section through a fine via portion, it was determined that the via had been sufficiently filled by the metal. The resistivity (ρ) of the deposited material (copper layer) was measured at 1.75 *µ* Ω·cm. The copper plating layer on the flat portion of the substrate had a thickness of about 1000 nm.

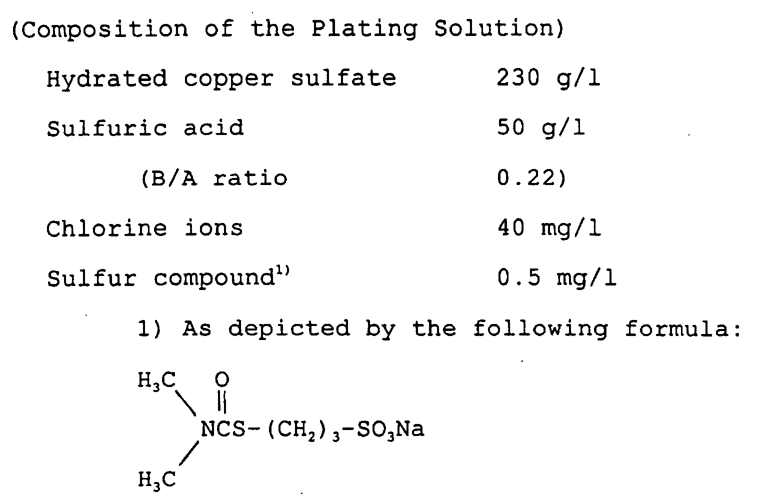

| (Plating Conditions) | |
|---|---|
| Bath temperature | 25°C |
| Current density | 1 A/dm² |
| Plating time | 5 minutes |

### [Second Embodiment]

The exact same sample used in the first embodiment was plated in the second embodiment using a copper sulfate solution with the composition shown below under the conditions described below. The wafer had a semi-gloss appearance after plating, and the via section exhibited good filling. The resistivity was 1.95 *µ* Ω·cm, while the thickness of the plating layer on the flat surface was measured at 1000 nm.

| (Composition of the Plating Solution) | |
|---|---|
| Hydrated copper sulfate | 20 g/l |
| Sulfuric acid | 200 g/l |
| (B/A ratio | 10) |
| Chlorine ions | 40 mg/l |
| Sulfur compound¹⁾ | 30 mg/l |

| | |
|---|---|
| 1) The same compound used in the first embodiment. | |

| (Plating Conditions) | |
|---|---|
| Bath temperature | 25°C |
| Current density | 1 A/dm² |
| Plating time | 5 minutes |

### [Third Embodiment]

The exact same sample used in the first embodiment was plated in the third embodiment using a copper sulfate solution with the composition shown below under the conditions described below. The wafer had a glossy appearance after plating, and the via section exhibited good filling. The resistivity was 1.8 *µ* Ω·cm, while the thickness of the plating layer on the flat surface was measured at 800 nm.

| (Composition of the Plating Solution) | |
|---|---|
| Hydrated copper sulfate | 120 g/l |
| Sulfuric acid | 120 g/l |
| (B/A ratio | 1) |
| Chlorine ions | 40 mg/l |
| Sulfur compound²⁾ | 2 mg/l |
| Polyethylene glycol 6000 | 0.1 g/l |

| | |
|---|---|
| 2) As depicted by the following formula: NaO₃S- (CH₂)₃-S-S- (CH₂)₃-SO₃Na | |

| (Plating Conditions) | |
|---|---|
| Bath temperature | 25°C |
| Current density | 2 A/dm² |
| Plating time | 2 minutes |

### [Fourth Embodiment]

The exact same sample used in the first embodiment was plated in the fourth embodiment using a copper sulfate solution with the composition shown below under the conditions described below. The wafer had a glossy appearance after plating, and the via section exhibited good filling. The resistivity was 1.9 *µ* Ω·cm, while the thickness of the plating layer on the flat surface was measured at 1000 nm.

| (Composition of the Plating Solution) | |
|---|---|
| Hydrated copper sulfate | 75 g/l |
| Sulfuric acid | 180 g/l |
| (B/A ratio | 2.4) |
| Chlorine ions | 40 mg/l |
| Sulfur compound¹⁾ | 2 mg/l |
| Polypropylene 400 | 0.2 g/l |
| Nitrogen compound³⁾ | 2 mg/l |

| | |
|---|---|
| 1) The same compound used in the first embodiment. | |
| 3) Safranine compound (janus green B) | |

| (Plating Conditions) | |
|---|---|
| Bath temperature | 25°C |
| Current density | 1 A/dm² |
| Plating time | 5 minutes |

### [Fifth Embodiment]

The exact same sample used in the first embodiment was plated in the fifth embodiment using a copper sulfate solution with the composition shown below under the conditions described below. The wafer had a glossy appearance after plating, and the via section exhibited good filling. The resistivity was 1.8 *µ* Ω·cm, while the thickness of the plating layer on the flat surface was measured at 500 nm.

| (Composition of the Plating Solution) | |
|---|---|
| Hydrated copper sulfate | 120 g/l |
| Sulfuric acid | 120 g/l |
| (B/A ratio | 1) |
| Chlorine ions | 60 mg/l |
| Sulfur compound¹⁾ | 2 mg/l |
| Nitrogen compound⁴⁾ | 8 mg/l |

| | |
|---|---|
| 1) The same compound used in the second embodiment. | |
| 4) Thioflavin T (manufactured by Wako Pure Chemicals Industries, Ltd.) | |

| (Plating Conditions) | |
|---|---|
| Bath temperature | 25°C |
| Current density | 0.5 A/dm² |
| Plating time | 5 minutes |

### [Sixth Embodiment]

The exact same sample used in the first embodiment was plated in the sixth embodiment using a copper sulfate solution with the composition shown below under the conditions described below. The wafer had a glossy appearance after plating, and the via section exhibited good filling. The resistivity was 1.85 *µ* Ω·cm, while the thickness of the plating layer on the flat surface was measured at 1000 nm.

| (Composition of the Plating Solution) | |
|---|---|
| Hydrated copper sulfate | 230 g/l |
| Sulfuric acid | 50 g/l |
| (B/A ratio | 0.22) |
| Chlorine ions | 40 mg/l |
| Sulfur compound¹⁾ | 1 mg/l |
| Nitrogen compound⁵⁾ | 8 mg/l |

| | |
|---|---|
| 1) The same compound used in the second embodiment. | |
| 5) Polyethylene imine (PEI-6) | |

| (Plating Conditions) | |
|---|---|
| Bath temperature | 25°C |
| Current density | 1 A/dm² |
| Plating time | 5 minutes |

### [First Comparison]

The exact same sample used in the first embodiment was plated in the first comparison using a copper sulfate solution with the composition shown below under the conditions described below. The wafer had a matte appearance after plating. The via section exhibited poor filling due to the large size of the copper grains leaving many gaps. The resistivity was 1.9 *µ* Ω · cm, while the thickness of the plating layer on the flat surface was measured at 1000 nm.

| (Composition of the Plating Solution) | |
|---|---|
| Hydrated copper sulfate | 230 g/l |
| Sulfuric acid | 50 g/l |
| (B/A ratio | 0.22) |
| Chlorine ions | 40 mg/l |
| Sulfur compound¹⁾ | 30 mg/l |

| | |
|---|---|
| 1) The same compound used in the first embodiment. | |

| (Plating Conditions) | |
|---|---|
| Bath temperature | 25°C |
| Current density | 1 A/dm² |
| Plating time | 5 minutes |

### [Second Comparison]

The exact same sample used in the first embodiment was plated in the second comparison using a copper sulfate solution with the composition shown below under the conditions described below. While the wafer had a glossy appearance after plating, the solution exhibited poor filling capability as voids (air holes) were present in the via section. The resistivity was 2.0 µ Ω·cm, while the thickness of the plating layer on the flat surface was measured at 1000 nm.

| (Composition of the Plating Solution) | |
|---|---|
| Hydrated copper sulfate | 20 g/l |
| Sulfuric acid | 200 g/l |
| (B/A ratio | 10) |
| Chlorine ions | 40 mg/l |
| Sulfur compound²⁾ | 0.5 mg/l |
| Polyethylene glycol 6000 | 0.1 g/l |
| Nitrogen compound³⁾ | 2 mg/l |

| | |
|---|---|
| 2) The same compound used in the third embodiment. | |
| 3) The same compound used in the fourth embodiment. | |

| (Plating Conditions) | |
|---|---|
| Bath temperature | 25°C |
| Current density | 1 A/dm² |
| Plating time | 5 minutes |

### [Third Comparison]

The exact same sample used in the first embodiment was plated in the third comparison using a copper sulfate solution with the composition shown below under the conditions described below. While the wafer had a glossy appearance after plating, the solution exhibited poor filling capability as there were voids (air holes) leading to the surface of the via section. The resistivity was 1.95 *µ* Ω · cm, while the thickness of the plating layer on the flat surface was measured at 800 nm.

| (Composition of the Plating Solution) | |
|---|---|
| Hydrated copper sulfate | 20 g/l |
| Sulfuric acid | 200 g/l |
| (B/A ratio | 10) |
| Chlorine ions | 40 mg/l |
| Sulfur compound²⁾ | 1 mg/l |
| Polypropylene glycol 400 | 200 mg/l |

| | |
|---|---|
| 2) The same compound used in the third embodiment. | |

| (Plating Conditions) | |
|---|---|
| Bath temperature | 25°C |
| Current density | 2 A/dm² |
| Plating time | 2 minutes |

By using the copper damascene plating solution of the present invention, copper metal can be efficiently deposited in fine wiring trenches and vias formed in a semiconductor wafer. Accordingly, the solution can be used to perform efficient and economical copper or copper alloy plating to form highly integrated wiring patterns on a semiconductor wafer.

The basic composition of the copper damascene wire plating solution according to the second embodiment of the present invention is copper sulfate (CuSO₄·5H₂O) having a concentration of 100-250 g/l, sulfuric acid (H₂SO₄) having a concentration of 10-100 g/l, and chlorine ions having a concentration of 0-100 mg/l.

The plating solution further comprises at least 0.14-70 *µ*mol/l of a sulfur compound expressed by the chemical formula in [A] below, 10 mg/1-5 g/l of a high polymer expressed by the chemical formula in [B] below, and 0.01-100 mg/l of a nitrogen compound.

X-L-(S)ₙ-L-X [A]

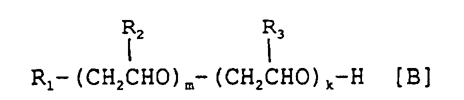

In [A], L is an alkyl group with a carbon number from 1 to 6 that can be replaced by a lower alkyl group, a lower alkoxyl group, a hydroxyl group, or a halogen atom; and X is a hydrogen atom, a -SO₃M group, or a -PO₃M group (M indicating a hydrogen atom, an alkali metal atom, or an amino group). In [B], R₁ indicates a higher alcohol rest group having carbon number of 8-25, an alkylphenol rest group with an alkyl group of carbon number 1-25, an alkylnaphthol rest group with an alkyl group of carbon number 1-25, a fatty acid amide rest group of carbon number 3-22, an alkylamine rest group of carbon number 2-4, or a hydroxyl group; R₂ and R₃ indicate a hydrogen atom or a methyl group; and m and k indicate an integer from 1 to 100.

To prevent copper ions in trenches and vias from becoming diffusion-controlled even when higher integration of semiconductor devices decreases the trench widths and via hole diameters, it is effective to produce a thinner diffusion layer by agitating the plating solution and restrain the current density. It is also effective to increase in copper concentration in the plating fluid. By an increase in copper concentration in the plating fluid, the diffusion rate increases proportionally. Of course, by agitating the plating solution, the diffusion rate increases further rapidly.

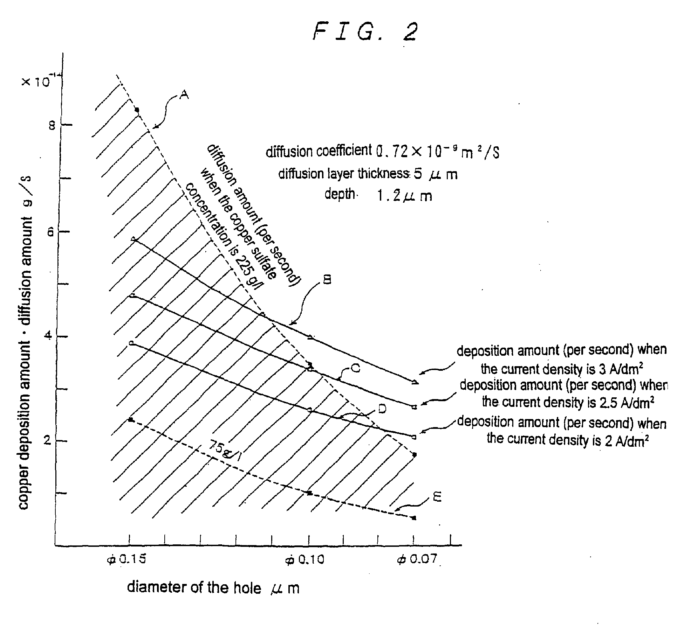

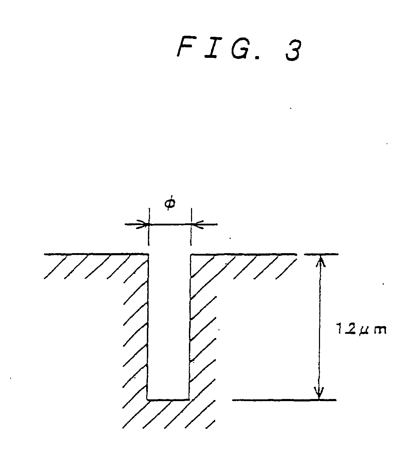

Figs. 2 and 3 show a comparison of the diffusion amount and deposition amount in a hole H having a depth of 1.2 *µ* m. In the Fig. 2, the Y-axis represents the copper deposition amount and diffusion amount (g/s), while the X-axis represents the diameter φ of the hole H (*µ* m) . Here, the diffusion coefficient is set at 0.72×10⁹ m²/s and the diffusion layer thickness at 5 *µ* m. When the diffusion amount is greater than the deposition amount, the ions become reaction-controlled preventing a depletion in copper ions in the hole H and the generation of voids therein. When the diffusion amount is less than the deposition amount, the ions become diffusion-controlled and voids are generated in the hole H. As seen in Fig. 2, higher concentrations of copper sulfate are advantageous when the hole diameter φ becomes finer, while the sulfuric acid concentration declines in comparison, due to the relationship of saturation and concentration. By reducing the sulfuric acid concentration, the electrical resistance of the solution increases, improving the uniformity of the deposited layer thickness.

In Fig. 2, curve A indicates the diffusion amount (per second) when the copper sulfate concentration is 225 g/l; curve B indicates the deposition amount (per second) when the current density is 3 A/dm²; curve C indicates the deposition amount (per second) when the current density is 2.5 A/dm²; curve D indicates the deposition amount (per second) when the current density is 2 A/dm²; and curve E indicates the diffusion amount (per second) when the copper sulfate concentration is 75 g/l.

As described above, the plating solution includes the sulfur compound shown in formula [A] of 0.14-40 *µ* mol and the high polymer shown in formula[B]. This sulfur compound can achieve a dense deposition. Some examples of these compounds include N, N-dimethyldithiocarbamoyl propylsulfonic acid, O-ethyl-S-(3-propylsulfonic acid)-dithiocarbonate, bis-(sulfopropyl) disulfide, and their salts.

In the present invention, the amount of additive in the sulfur compound should be 0.14-70 *µ* mol/l, since the copper sulfate is greater than the amount of sulfuric acid. Less additive is used when using a solution with a low concentration of copper sulfate, because the cathode vicinity is rich in copper ions, requiring less sulfur compound as an accelerator.

Some examples of a high molecular organic additive contained in the plating solution are PPG and PEG, their random or block polymers, or a derivative thereof, such as a polyether type. The amount of high-molecular organic additive is approximately 10 mg/1-5 g/l.

A leveler is added to the above plating solution to further suppress the copper deposition and accelerate plating growth in the bottom of the hole. The leveler is a nitrogen compound containing a phenazine compound, phthalocyanine compound, polyethylene imine, polybenzyl ethylene imine, or other polyalkylene imine and derivatives thereof; an N-dye substitute compound or other thiorurea derivative; a phenosafranine, safranine azo naphthol, diethyl safranine azo phenol, dimethyl safranine dimethyl aniline, or other safranine compound; a polyepichlorohydrine and a derivative thereof; a thioflavine or other phenylthiazonium compound; an acrylamide, propylamide, polyacrylic acid amide, or other amide type. This nitrogen compound additive is approximately 0.01-100 mg/l.

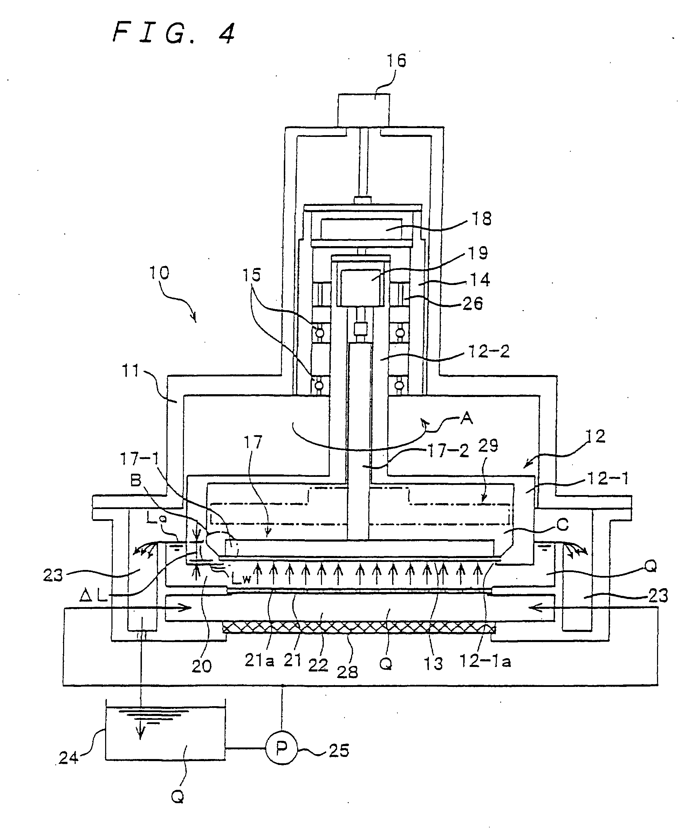

Fig. 4 shows an example construction of a plating apparatus for performing the plating method of the present invention. As shown in the diagram, the plating apparatus is provided with a plating bath 10. The plating bath 10 includes a main bath 11 and a retaining member 12 accommodated by the main bath 11 for retaining a wafer 13, such as a semiconductor wafer. The retaining member 12 includes a retaining unit 12-1 and a shaft unit 12-2. The shaft unit 12-2 is rotatably supported in a cylindrical guide member 14 via bearings 15 provided on the inner wall thereof. A cylinder 16 provided on the top of the main bath 11 drives the guide member 14 and retaining member 12 up and down at a prescribed stroke.

A motor 18 is disposed at the inner top of the guide member 14 for rotating the retaining member 12 in the direction indicated by the arrow A via the shaft unit 12-2. A pressing member 17 comprises a pressing unit 17-1 and a shaft unit 17-2. The pressing member 17 is accommodated in a space C formed in the retaining member 12. A cylinder 19 disposed in the top portion of the shaft unit 12-2 raises and lowers the pressing member 17 at a prescribed stroke.

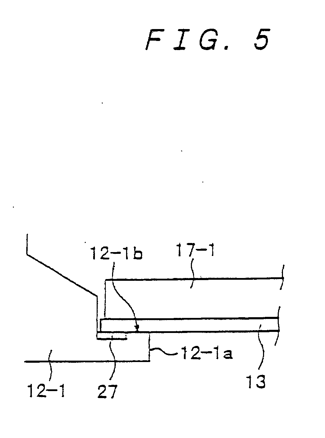

An opening 12-la is formed at the bottom of the retaining unit 12-1 and is in fluid communication with the space C. A step portion 12-lb is formed at the top of the opening 12-la for supporting the edge of the wafer 13, as shown in Fig. 14. After the wafer 13 is placed on the step portion 12-lb, the pressing unit 17-1 is pressed against the top surface of the wafer 13 to clamp the edge of the wafer 13 between the pressing unit 17-1 and the step portion 12-lb. At this time, the bottom surface (plating surface) of the wafer 13 is exposed in the opening 12-la. Fig. 5 shows an enlarged view of the area B indicated in Fig. 4.

A flattened plating solution chamber 20 is formed below the retaining unit 12-1, that is, below the plating surface of the wafer 13 exposed in the opening 12-la. A flat plating solution introducing chamber 22 is provided below the plating solution chamber 20. Plating solution is supplied to the plating solution chamber 20 via a plurality of holes 21a formed in a perforated plate 21. The perforated plate 21 is disposed between the two chambers. A recovery gutter 23 is disposed around the plating solution chamber 20 for collecting plating solution Q that overflows from the plating solution chamber 20.

The plating solution Q recovered in the recovery gutter 23 is returned to a plating solution tank 24. A pump 25 introduces the plating solution from the plating solution tank 24 horizontally into both ends of the plating solution introducing chamber 22. The plating solution Q introduced into both sides of the plating solution introducing chamber 22 is forced through the holes 21a formed in the perforated plate 21 and introduced into the plating solution chamber 20. The wafer 13 is separated from the perforated plate 21 by a distance of 5-15 mm in order that the plating solution Q passing through the perforated plate 21 contacts the plating surface of the wafer 13 in a uniform flow that maintains its vertical upward direction. The plating solution Q overflowing from the plating solution chamber 20 is recovered in the recovery gutter 23 and returned to the plating solution tank 24. In other words, the plating solution Q is circulated between the plating solution chamber 20 and the plating solution tank 24.

The level LQ of the plating solution in the plating solution chamber 20 is set slightly higher (ΔL) than the level LQ of the plating surface on the wafer 13. Accordingly, the plating solution Q contacts the entire surface of the wafer 13.

The step portion 12-lb is provided with an electrical contact 27 that provides an electrical connection to the conducting portion of the wafer 13. The wafer 13 is connected to the cathode of an external power source (not shown) via a brush 26. An anode 28 is provided on the bottom of the plating solution introducing chamber 22 and opposes the wafer 13. The anode 28 is connected to the anode of the power source. A slit 29 is formed at a prescribed position in the side surface of the main bath 11 for inserting and removing the wafer 13 by a plate conveying jig, such as a robot arm.

When conducting a plating process in the electrolytic plating unit described above, the cylinder 16 is operated to raise the retaining member 12 and guide member 14 a prescribed distance (to a position at which the wafer 13 maintained on the retaining unit 12-1 opposes the slit 29). Next, the cylinder 19 is operated to raise the pressing member 17 a prescribed distance (to a position at which the pressing unit 17-1 reaches the top of the slit 29). At this time, a robot arm or other conveying jig inserts a wafer 13 into the space C of the retaining member 12. The wafer 13 is placed on the step portion 12-1b, such that the plating surface faces downward. In this state, the cylinder 19 is operated to lower the pressing member 17 until the bottom surface of the pressing unit 17-1 contacts the top surface of the wafer 13, thereby gripping the edge of the wafer 13 between the pressing unit 17-1 and the step portion 12-lb.

Next, the cylinder 16 is operated to lower the retaining member 12 and guide member 14 until the plating surface of the wafer 13 contacts the plating solution Q in the plating solution chamber 20 (to a position exactly ΔL lower than the plating solution level LQ). During this time, the motor 18 is driven to rotate the retaining member 12 and the wafer 13 at a slow rate of speed as they are lowered. Next, the plating solution chamber 20 is filled with plating solution Q, causing the solution to be ejected through the holes 21a and flow vertically upward. At this time, the power source applies a prescribed voltage between the anode 28 and electrical contact 27, generating a current flowing from the anode 28 to the wafer 13 and forming a plating layer on the plating surface of the same.

During the plating process, the motor 18 is driven to rotate the retaining member 12 and the wafer 13 at a slow rate of speed. The rotations are set at a speed that does not disturb the vertical ejection of the plating solution Q in the plating solution chamber 20, but enables a plating layer of uniform thickness to be formed on the plating surface of the wafer 13.

When the plating process is completed, the cylinder 16 is driven to raise the retaining member 12 and the wafer 13 until the bottom surface of the retaining unit 12-1 is higher than the plating solution level LQ. The motor 18 rotates the retaining member 12 at a high rate of speed, causing plating solution still deposited on the plating surface of the wafer 13 and the bottom surface of the retaining unit 12-1 to be spun off by the centrifugal force. After spinning off the plating solution, the wafer 13 is raised to a position corresponding to the slit 29. Next, the cylinder 19 is operated to raise the pressing unit 17-1, thereby releasing the wafer 13 and leaving the wafer 13 on the step portion 12-lb. The robot arm enters the space C of the retaining member 12 via the slit 29, picks up the wafer 13, and conveys the wafer 13 externally.

A satisfactory filling capacity was achieved by a plating solution Q under the following conditions when using the electrolytic plating unit 71 described above. The plating solution Q had a current density of 2 A/dm², a temperature of 25°C, and a plating time of 150 seconds, wherein the vias formed in the wafer 13 had a diameter of 0.15 *µ* m and a depth of 1.2 *µ*m. The composition of the plating solution Q was as follows.

| | |
|---|---|
| CuSO₄·5H₂O | 225 g/l |
| H₂SO₄ | 55 g/l |
| Cl⁻ | 60 mg/l |
| Sulfur compound (N, N-dimethyldithiocarbamoyl propylsulfonic acid) | 5 mg/l |
| High polymer (PEG6000) | 0.1 g/l |
| Nitrogen compound (safranine compound, janus green B) | 2 mg/l |

By using a plating solution with a high concentration of copper sulfate (CuSO₄·5H₂O), as described above, a copper plating with good filling ability for a hole diameter of 0.15 *µ* m and a depth of 1.2 *µ* m can be achieved.

In the embodiments described above, various compositions of the plating solution were described for use in copper plating, but the present invention is not limited to these compositions. However, it is not difficult to predict that a copper plating with the same filling quality can be achieved when using the above-described plating solution compositions in the substrate plating method.

Further, the construction of the plating apparatus according to the present invention is not limited to that shown in Fig. 4. However, the plating apparatus should employ a plating solution with a 10-250 g/l concentration of copper sulfate (CuSO₄·5H₂O), 10-100 g/l of sulfuric acid (H₂SO₄), and 0-100 mg/l of chlorine ions. The apparatus should dispose a plating substrate and anode in the plating solution contained in a plating bath and apply a prescribed voltage across the two.

A plating solution having a high concentration of copper sulfate and a 0-100 mg/l concentration of chlorine ions can increase the diffusion speed of copper ions and produce a good filling quality in the fine trenches and vias formed in the surface of the substrate.

### Industrial Applicability

The present invention can be applied to a substrate plating method and apparatus for filling wiring trenches and via holes that are formed in a semiconductor wafer, or the like, with a copper plating.

## Claims

1. A plating method for filling trenches or via holes formed in a surface of a substrate with copper plating, the method comprising:
performing electrolytic plating using a plating solution comprising copper sulfate (CuSO₄·5H₂O) having a concentration of 4-250 g/l, sulfuric acid (H₂SO₄) having a concentration of 10-200 g/l, and chlorine ions having a concentration of 0-100 mg/l.

2. A plating method as recited in claim 1, wherein the plating solution further comprises at least 0.14-70 *µ* mol/l of a sulfur compound expressed by the formula in [A] below, 10-5000 mg/l of a high polymer expressed by the formula [B] below, and 0.01-100 mg/l of a nitrogen compound;
X-L-(S)ₙ-L-X [A] 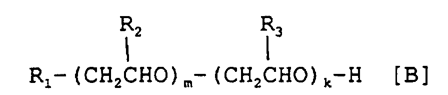
wherein L is an alkyl group with a carbon number from 1 to 6 that can be replaced by a lower alkyl group, a lower alkoxyl group, a hydroxyl group, or a halogen atom; and X is a hydrogen atom, a -SO₃M group, or a -PO₃M group (M indicating a hydrogen atom, an alkali metal atom, or an amino group) in [A]; and
R₁ indicates a higher alcohol rest group having carbon number of 8-25, an alkylphenol rest group with an alkyl group of carbon number 1-25, an alkylnaphthol rest group with an alkyl group of carbon number 1-25, a fatty acid amide rest group of carbon number 3-22, an alkylamine rest group of carbon number 2-4, or a hydroxyl group; R₂ and R₃ indicate a hydrogen atom or a methyl group; and m and k indicate an integer from 1 to 100 in [B].

3. An apparatus for plating a substrate by an electrolytic plating method, the apparatus comprising:
a plating bath accommodating a plating solution;
an anode disposed with the substrate to be plated in the plating bath; and
means for applying a prescribed voltage between the plating substrate and the anode;
wherein the plating solution comprises copper sulfate (CuSO₄·5H₂O) having a concentration of 4-250 g/l, sulfuric acid (H₂SO₄) having a concentration of 10-200 g/l, and chlorine ions having a concentration of 0-100 mg/l.

4. A plating apparatus as recited in claim 3, wherein the plating solution further comprises at least 0.14-70 *µ* mol/l of a sulfur compound expressed by the formula in [A] below, 10-5000 mg/l of a high polymer expressed by the formula [B] below, and 0.01-100 mg/l of a nitrogen compound;
X-L-(S)ₙ-L-X [A] 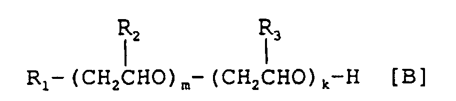
wherein L is an alkyl group with a carbon number from 1 to 6 that can be replaced by a lower alkyl group, a lower alkoxyl group, a hydroxyl group, or a halogen atom; and X is a hydrogen atom, a -SO₃M group, or a -PO₃M group (M indicating a hydrogen atom, an alkali metal atom, or an amino group) in [A]; and
R₁ indicates a higher alcohol rest group having carbon number of 8-25, an alkylphenol rest group with an alkyl group of carbon number 1-25, an alkylnaphthol group with an alkyl group of carbon number 1-25, a fatty acid amide rest group of carbon number 3-22, an alkylamine rest group of carbon number 2-4, or a hydroxyl group; R₂ and R₃ indicate a hydrogen atom or a methyl group; and m and k indicate an integer from 1 to 100 in [B].

5. A plating solution for copper damascene wiring comprising:
copper sulfate having a concentration of 4-250 g/l;
sulfuric acid having a concentration of 10-200 g/l; and
chlorine ions having a concentration of 0-100 mg/l.

6. A plating solution for copper damascene wiring as recited in claim 5, further comprising a sulfur compound of 0.14-70 *µ*mol/l when the ratio of sulfuric acid/hydrated copper sulfate is less than 1 and 0.14-150 *µ*mol/l when the ratio of sulfuric acid/hydrated copper sulfate is greater than 1.

7. A plating solution for copper damascene wiring as recited in claim 6, wherein the sulfur compound is an alkylene polysulfide compound expressed by the formula(I)
Y-(S)ₙ-L-X (I),
where L is an alkylene group with a carbon number from 1 to 6 that can be replaced by a lower alkyl group, a lower alkoxyl group, a hydroxyl group, or a halogen atom; X is a hydrogen atom, a -SO₃M group, or a -PO₃M group (M indicating a hydrogen atom, an alkali metal atom, or an amino group) ; and Y is an alkylaminocarbothio group or the group;
-L'-X'
(where L' is an alkylene group with a carbon number from 1 to 6 that can be replaced by a lower alkyl group, a lower alkoxyl group, a hydroxyl group, or a halogen atom; and X' is a -SO₃M group or a -PO₃M group); and n is an integer between 1 and 5.

8. A plating solution for copper damascene wiring as recited in claim 6 or 7, further comprising a high polymer expressed by a formula(II); 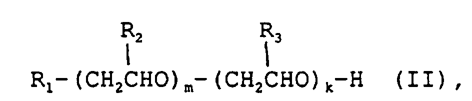 wherein R₁ indicates a higher alcohol rest group having carbon number of 8-25, an alkylphenol rest group with an alkyl group of carbon number 1-25, an alkylnaphthol group with an alkyl group of carbon number 1-25, a fatty acid amide rest group of carbon number 3-22, an alkylamine rest group of carbon number 2-4, or a hydroxyl group; R₂ and R₃ indicate a hydrogen atom or a methyl group; and m and k indicate an integer from 1 to 100.
